# EUROPEAN PATENT APPLICATION

(11) **EP 4 761 028 A1**
(43) Date of publication of application: **17.06.2026**
(21) Application number: 25209399.2
(22) Date of filing: 17.10.2025
(51) Int. Cl.: H02H 3/04, G01R 31/74, H02H 3/05, H02H 7/18, H02H 3/087, B60L 3/04, H02H 5/10

(54) **FUSE DEVICE, BATTERY MANAGEMENT SYSTEM, AND BATTERY PACK**

(30) Priority: 10.12.2024 KR 20240182852
(71) Applicant: SAMSUNG SDI CO., LTD., Yongin-si, Gyeonggi-do 17084 (KR)
(72) Inventor: CHO, Kyu Sung, Suwon-si 17084 (KR)
(74) Representative: Marks & Clerk LLP

(57) **Abstract**

The present disclosure relates to a fuse device, a battery management system, and a battery pack. A diagnostic current supply circuit (30) is connected to a first fuse element and a second fuse element (F2) to allow a diagnostic current to flow in the first and second fuse element (F2)s, an ignition circuit (20) is connected to the first fuse element and the second fuse element (F2) to allow an ignition current to flow in the first and second fuse element (F2)s. The diagnosing by controlling the diagnostic current supply circuit (30) and the igniting by controlling the ignition circuit (20) are independently performed.

## Description

### BACKGROUND

### 1. Field

The present disclosure relates to a fuse device, a battery management system, and a battery pack.

### 2. Description of the Related Art

A battery pack includes battery cells and a peripheral circuit including a charge/discharge circuit. The peripheral circuit is manufactured as a printed circuit board and then connected to the battery cells. When an external power source is connected to external terminals of the battery pack, the battery cells undergo charging, and when a load is connected to the external terminals, the battery cells undergo discharging. Here, the charge/discharge circuit controls the charging/discharging of the battery cells between the external terminals and the battery cells. In general, a plurality of battery cells are connected in series and/or in parallel according to the consumption capacity of a load.

When the battery pack experiences an abnormal power supplying operation, for example, an overcurrent flows from the battery pack to a load, it is necessary to block a current path connected to a battery (that is, a current path connecting battery cells to the load) to protect the battery pack, the load, the product to which the battery pack supplies the current, and the user. To this end, a fuse is commonly used to physically cut off the current path connected to the battery to block the flow of current.

This Background section is for the general understanding of the background of the present disclosure, and therefore, it may contain information that does not constitute related (or prior) art.

### SUMMARY

The present disclosure is directed to a fuse device, which is capable of independently performing diagnostic and ignition on a fuse and concurrently performing diagnosis and ignition on a plurality of fuse elements, a battery management system, and a battery pack.

Embodiments of the present disclosure provide a fuse device for diagnosing and igniting a fuse, the fuse device including, a first fuse element and a second fuse element configured to block a current path connected to a battery, a diagnostic current supply circuit connected to the first fuse element and the second fuse element through a first node and a second node and configured to allow a diagnostic current for diagnosing the first fuse element and the second fuse element to flow in the first fuse element and the second fuse element, and an ignition circuit connected to the first fuse element and the second fuse element through a first branch path and a second branch path respectively branching off from the first node and the second node and configured to allow an ignition current for igniting the first fuse element and the second fuse element to flow in the first fuse element and the second fuse element.

Embodiments of the present disclosure provide a fuse device for diagnosing and igniting a fuse, the fuse device including: a first fuse element and a second fuse element, each configured to block a current path connected to a battery; a diagnostic current supply circuit connected to the first fuse element and the second fuse element through a first node and a second node, respectively, the diagnostic current supply circuit configured to allow a diagnostic current to flow in each of the first fuse element and the second fuse element; and an ignition circuit connected to the first fuse element and the second fuse element through a first branch path and a second branch path, respectively, each branching off from the first node and the second node, respectively, the ignition circuit configured to allow an ignition current to flow in each of the first fuse element and the second fuse element.

In some embodiments, the fuse device may further include a first current induction element and a second current induction element respectively connected to the first branch path and the second branch path and configured to induce the ignition current to flow from the first node and the second node to the ignition circuit.

In some embodiments, the fuse device further includes a first current induction element and a second current induction element connected to the first branch path and the second branch path, respectively, and the first current induction element and the second current induction element each configured to induce the ignition current to flow from the first node and from the second node, respectively, to the ignition circuit.

In some embodiments, the ignition circuit may include an ignition switch turned on in response to an input of at least one of a first ignition signal and a second ignition signal to generate the ignition current in the first fuse element and the second fuse element, the first ignition signal may be applied by a first processor configured to control an operation of the fuse device, and the second ignition signal may be applied by a second processor serving as an upper level controller for the first processor.

In some embodiments, the ignition circuit includes an ignition switch configured to be turned on in response to an input of a first ignition signal or a second ignition signal to generate the ignition current in the first fuse element and the second fuse element, wherein the first ignition signal is applied by a first processor configured to control the fuse device, and wherein the second ignition signal is applied by a second processor corresponding to an upper level controller to the first processor.

In some embodiments, the diagnostic current supply circuit may include a first switch, a second switch, a first resistor connected to the first switch, and a second resistor connected to the second switch, when the first switch is turned on, the diagnostic current for the first fuse element may flow along a current path along which the first fuse element, the first node, the first switch, the first resistor, and a ground node are connected, and when the second switch is turned on, the diagnostic current for the second fuse element may flow along a current path along which the second fuse element, the second node, the second switch, the second resistor, and the ground node are connected.

In some embodiments, the diagnostic current supply circuit includes a first switch, a second switch, a first resistor connected to the first switch, and a second resistor connected to the second switch, wherein when the first switch is turned on, the diagnostic current for the first fuse element flows along a current path where the first fuse element, the first node, the first switch, the first resistor, and a ground node are connected, and wherein when the second switch is turned on, the diagnostic current for the second fuse element flows along a current path where the second fuse element, the second node, the second switch, the second resistor, and the ground node are connected.

In some embodiments, the diagnostic current may be a constant current of which a magnitude is determined by resistance values of the first resistor and the second resistor.

In some embodiments, the diagnostic current is a constant current of which a magnitude is determined by a resistance value of the first resistor or the second resistor.

In some embodiments, the fuse device may further include a resistance monitoring circuit including a first monitoring circuit configured to monitor a resistance value of an internal resistor of the first fuse element, and a second monitoring circuit configured to monitor a resistance value of an internal resistor of the second fuse element.

In some embodiments, the first monitoring circuit may include a first amplifier configured to amplify a voltage of the first fuse element, and the second monitoring circuit may include a second amplifier configured to amplify a voltage of the second fuse element.

In some embodiments, the fuse device may further include a driving circuit configured to allow or block a current flowing from a power node, to which a power voltage is applied, to the first fuse element and the second fuse element.

In some embodiments, the fuse device further includes a driving circuit configured to allow or block a current flowing from a power node to the first fuse element or the second fuse element.

In some embodiments, when the resistance value of the internal resistor of the first fuse element or the resistance value of the internal resistor of the second fuse element monitored by the resistance monitoring circuit is outside a preset reference range, the driving circuit may be configured to block the current flowing to the first fuse element and the second fuse element.

In some embodiments, when the resistance value of the internal resistor of the first fuse element or the resistance value of the internal resistor of the second fuse element is outside a preset reference range, the driving circuit is configured to block the current flowing to the first fuse element or the second fuse element.

Embodiments of the present disclosure provide a battery management system including, a first fuse element and a second fuse element configured to block a current path connected to a battery, a diagnostic current supply circuit connected to the first fuse element and the second fuse element and configured to allow a diagnostic current for diagnosing the first fuse element and the second fuse element to flow in the first fuse element and the second fuse element, an ignition circuit connected to the first fuse element and the second fuse element and configured to allow an ignition current for igniting the first fuse element and the second fuse element to flow in the first fuse element and the second fuse element, and a processor configured to control the diagnostic current supply circuit and the ignition circuit to independently perform a fuse diagnosis operation of diagnosing the first fuse element and the second fuse element and a fuse ignition operation of igniting the first fuse element and the second fuse element.

Embodiments of the present disclosure provide a battery management system including: a first fuse element and a second fuse element, each configured to block a current path connected to a battery; a diagnostic current supply circuit connected to each of the first fuse element and the second fuse element, the diagnostic current supply circuit configured to allow a diagnostic current to flow in each of the first fuse element and the second fuse element; an ignition circuit connected to each of the first fuse element and the second fuse element, the ignition circuit configured to allow an ignition current to flow in each of the first fuse element and the second fuse element; and a processor configured to control the diagnostic current supply circuit and the ignition circuit to independently perform diagnosing of the first fuse element and the second fuse element or perform igniting of the first fuse element and the second fuse element.

In some embodiments, the processor may control the diagnostic current supply circuit to allow a constant current having a predefined magnitude to flow in the first fuse element and the second fuse element as the diagnostic current.

In some embodiments, the processor is configured to control the diagnostic current supply circuit to allow a constant current having a predefined magnitude to flow in the first fuse element and the second fuse element as the diagnostic current.

In some embodiments, the fuse device may further include a resistance monitoring circuit including a first monitoring circuit configured to monitor a resistance value of an internal resistor of the first fuse element, and a second monitoring circuit configured to monitor a resistance value of an internal resistor of the second fuse element.

In some embodiments, the battery management system may further include a driving circuit configured to allow or block a current flowing from a power node, to which a power voltage is applied, to the first fuse element and the second fuse element, and when the resistance value of the internal resistor of the first fuse element and the resistance value of the internal resistor of the second fuse element are monitored, the processor may control the driving circuit to allow the current to flow from the power node to the first fuse element and the second fuse element.

In some embodiments, the battery management system further includes a driving circuit configured to allow or block a current flowing from a power node to the first fuse element or the second fuse element.

In some embodiments, the processor may control the diagnostic current supply circuit to allow the diagnostic current to flow in the first fuse element and the second fuse element when the resistance value of the internal resistor of the first fuse element and the resistance value of the internal resistor of the second fuse element are monitored, and may monitor the resistance value of the internal resistor of the first fuse element and the resistance value of the internal resistor of the second fuse element through the resistance monitoring circuit in a state in which the diagnostic current flows in the first fuse element and the second fuse element.

In some embodiments, the processor is configured to control the diagnostic current supply circuit to allow the diagnostic current to flow in the first fuse element or the second fuse element.

In some embodiments, the processor may monitor the resistance value of the internal resistor of the first fuse element and the resistance value of the internal resistor of the second fuse element based on a voltage of the first fuse element and a voltage of the second fuse element, which are detected through the resistance monitoring circuit, and a magnitude of the diagnostic current.

In some embodiments, the processor is configured to monitor the resistance value of the internal resistor of the first fuse element and the resistance value of the internal resistor of the second fuse element.

In some embodiments, when the resistance value of the internal resistor of the first fuse element or the resistance value of the internal resistor of the second fuse element monitored by the resistance monitoring circuit is outside a preset reference range, the processor may determine that an abnormality has occurred in the first fuse element or the second fuse element.

In some embodiments, when the resistance value of the internal resistor of the first fuse element or the resistance value of the internal resistor of the second fuse element is outside a preset reference range, the processor is configured to determine that an abnormality has occurred in the first fuse element or the second fuse element.

In some embodiments, when it is determined that the abnormality has occurred in the first fuse element or the second fuse element, the processor may control the driving circuit to block the current flowing from the power node to the first fuse element and the second fuse element.

In some embodiments, when the processor determines that the abnormality has occurred, the processor is configured to control the driving circuit to block the current flowing from the power node to the first fuse element or the second fuse element.

In some embodiments, the processor may determine whether the first fuse element or the second fuse element is shorted based on a voltage of the first fuse element and a voltage of the second fuse element detected through the resistance monitoring circuit, and may control the driving circuit to block the current flowing from the power node to the first fuse element and the second fuse element when a short circuit of the first fuse element or the second fuse element has been detected.

In some embodiments, the processor is configured to determine whether the first fuse element or the second fuse element is shorted based on a voltage of the first fuse element and a voltage of the second fuse element detected through the resistance monitoring circuit.

In some embodiments, the ignition circuit may be connected to each of the first fuse element and the second fuse element through a first current induction element and a second current induction element, and the processor may control the ignition circuit so that the ignition current simultaneously flows in the first fuse element and the second fuse element to simultaneously ignite the first fuse element and the second fuse element.

In some embodiments, the ignition circuit is connected to each of the first fuse element and the second fuse element via a first current induction element and a second current induction element, respectively.

Embodiments of the present disclosure provide a battery pack including a battery, a first fuse element and a second fuse element configured to block a current path connected to the battery, a diagnostic current supply circuit connected to the first fuse element and the second fuse element and configured to allow a diagnostic current for diagnosing the first fuse element and the second fuse element to flow in the first fuse element and the second fuse element, an ignition circuit connected to the first fuse element and the second fuse element and configured to allow an ignition current for igniting the first fuse element and the second fuse element to flow in the first fuse element and the second fuse element, and a processor configured to control the diagnostic current supply circuit and the ignition circuit to independently perform a fuse diagnosis operation for diagnosing the first fuse element and the second fuse element and a fuse ignition operation for igniting the first fuse element and the second fuse element.

Embodiments of the present disclosure provide a battery pack including: a battery; a first fuse element and a second fuse element, each configured to block a current path connected to the battery; a diagnostic current supply circuit connected to each of the first fuse element and the second fuse element, the diagnostic current supply circuit configured to allow a diagnostic current to flow in each of the first fuse element and the second fuse element; an ignition circuit connected to each of the first fuse element and the second fuse element, the ignition circuit configured to allow an ignition current to flow in each of the first fuse element and the second fuse element; and a processor configured to control the diagnostic current supply circuit and the ignition circuit to independently perform diagnosing of the first fuse element and the second fuse element or perform igniting of the first fuse element and the second fuse element.

At least some of the above and other features of the invention are set out in the claims.

### BRIEF DESCRIPTION OF THE DRAWINGS

The drawings illustrate embodiments of the present disclosure, and further describe aspects and features of the present disclosure along with the detailed description of the present disclosure. Thus, the present disclosure should not be construed as being limited to the drawings:
FIG. 1 is a block diagram illustrating a battery management system and a battery pack according to embodiments of the present disclosure;
FIG. 2 is a block diagram illustrating a fuse device according to embodiments of the present disclosure;
FIG. 3 illustrates a circuit diagram of the fuse device according to embodiments of the present disclosure;
FIGS. 4A to 4E are diagrams describing a fuse diagnostic operation of the fuse device according to embodiments of the present disclosure; and
FIG. 5 is a diagram describing a fuse ignition operation of the fuse device according to embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

### 1. Battery management system and battery pack

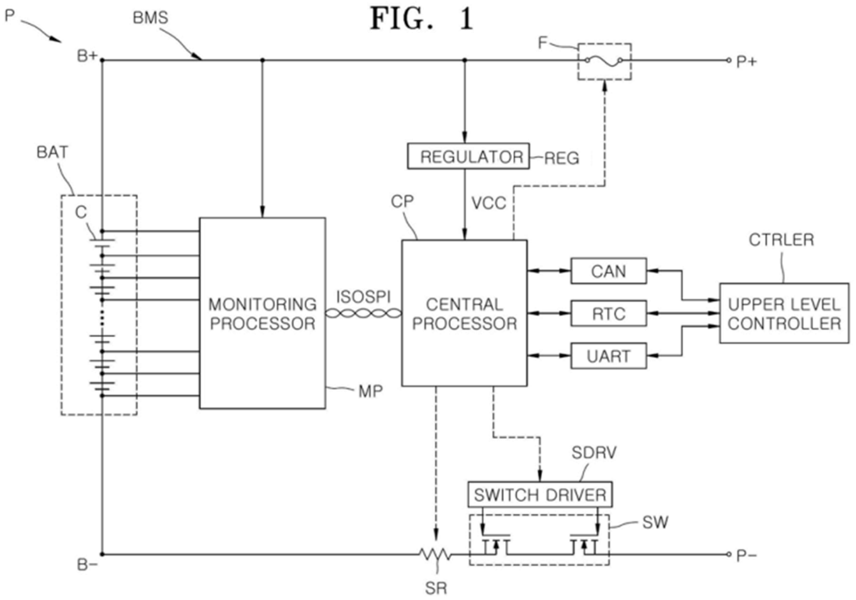

FIG. 1 is a block diagram illustrating a battery management system (BMS) and a battery pack.

Referring to FIG. 1, the BMS may include a monitoring processor MP, a central processor CP, a shunt resistor SR, a charge/discharge switch SW, a switch driver SDRV, a regulator REG, and a fuse device F. Together with a battery BAT, the BMS may constitute a battery pack P. The battery pack P may be used as a power supply device for small electronic devices such as a mobile phone, a laptop computer, or a camcorder, or used as a power supply device for industrial devices such as an electric vehicle (EV), a hybrid vehicle (HV), or an energy storage system (ESS). The present disclosure shows the battery pack P being applicable to an EV but is not limited thereto.

The battery BAT may correspond to a battery module in which a plurality of battery cells C are connected in series or in parallel (which may include a substructure in which a plurality of battery modules are connected in series or in parallel). When the battery pack P is applied to an EV, the battery BAT (for example, a lithium ion battery, a lithium polymer battery, a nickel cadmium battery, a nickel hydrogen battery, or a nickel zinc battery) may supply a relatively high voltage (for example, 400 V or 800 V). The battery BAT may be a main battery that supplies power to a load, that is, a driving system of an EV (for example, a driving motor and an inverter), to drive the driving system. The battery BAT may be charged by a charging current supplied from an external charging device. Separate from the main battery, the battery pack P may include an auxiliary battery (for example, a lead-acid battery) (not shown) to supply relatively low-voltage power (for example, 12 V) to an electrical system of an EV (for example, a lamp system, a wiper system, or an air conditioning system).

The monitoring processor MP may correspond to an analog front end integrated circuit (AFE IC) that monitors a state of each battery cell C and performs a battery cell control operation based on the monitoring results. For example, the monitoring processor MP may be configured to monitor a voltage, a current, a temperature, and a state of charge (SOC) of the battery cell C. The monitoring processor MP may be configured to perform control operations such as balancing control, temperature control, and charge/discharge control operations of the battery cell C based on the monitoring results. The monitoring processor MP may be configured to perform protection operations, such as a control operation of the charge/discharge switch SW, preventing over-discharging or over-charging. State data of the battery cell C (for example, a voltage, a current, a temperature, and an SOC of the battery cell C) acquired by the monitoring processor MP may be transmitted to the central processor CP through bidirectional isolated serial port interface (ISOSPI) communication.

The central processor CP may generate a control operation instruction or a protection operation instruction based on the state data of the battery cell C transmitted from the monitoring processor MP and may feed the control operation instruction or the protection operation instruction back to the monitoring processor MP, thereby causing the monitoring processor MP to perform the control operation and protection operation. The central processor CP that performs such a function may correspond to a microcontroller unit (MCU) of the BMS. The central processor CP may communicate with a upper level controller CTRLER (for example, an electronic control unit (ECU) of a vehicle equipped with the battery pack P) through a communication protocol such as a controller area network (CAN), real-time communication (RTC), or a universal synchronous receiver-transmitter (UART).

The shunt resistor SR may be connected to a path (corresponding to a charge/discharge path) connecting a positive terminal P+ of the battery pack P to a negative terminal P- of the battery pack P through the battery cell C and may serve as a resistor for detecting an overcurrent flowing in the battery cell C.

The charge/discharge switch SW may correspond to a metal oxide silicon field effect transistor (MOSFET) that controls a current flowing along the charge/discharge path, and the switch driver SDRV may correspond to a gate driver that controls an on/off operation of the charge/discharge switch SW under the control of the central processor CP.

A device that performs an operation of detecting an overcurrent through the shunt resistor SR and an operation of controlling an on/off operation of the charge/discharge switch SW by controlling the switch driver SDRV when an overcurrent is detected may correspond to the monitoring processor MP or the central processor CP. FIG. 1 illustrates by way of example, that the device performing such operations is the central processor CP. The central processor CP may detect a state in which an overcurrent flows to the battery cell C through the shunt resistor SR and may control the switch driver SDRV to turn the charge/discharge switch SW off, thereby preventing damage to the battery cell C caused by an overcurrent.

The regulator REG may regulate a voltage level at an uppermost node B+ of the plurality of battery cells C to be at a level corresponding to an operating voltage of the central processor CP, and an operating voltage VCC of the central processor CP may be generated by the regulator REG. The regulator REG may be implemented as a DC/DC converter that converts a voltage at the uppermost node B+ of the plurality of battery cells C into the operating voltage of the central processor CP.

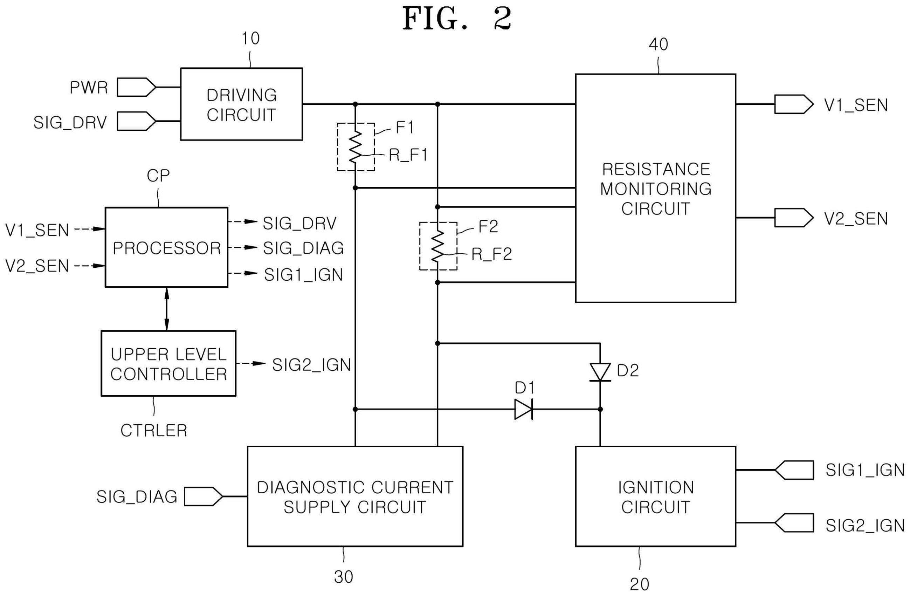

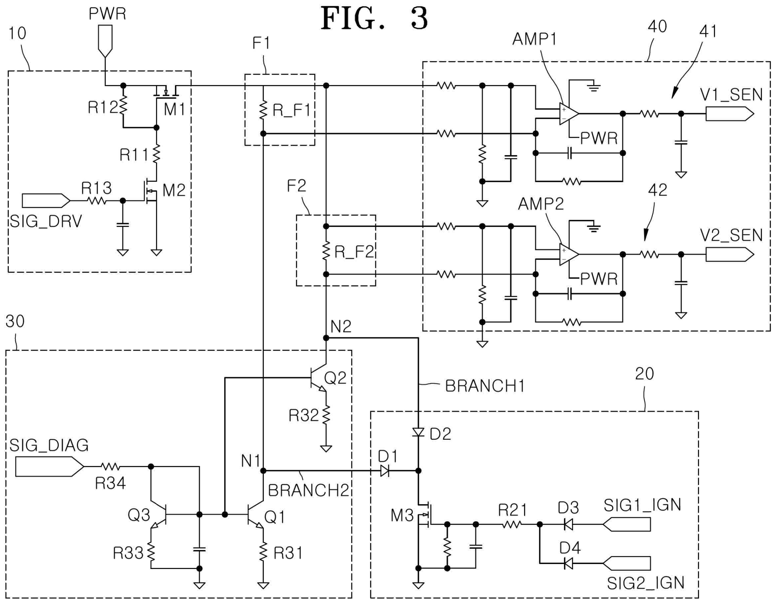

The fuse device F may be configured to block a current path (that is, the charge/discharge path) connected to the battery BAT (the blocking of the current path may mean the blocking of a current flow through physical cutting off the current path). The fuse device F (see figures 2 and 3) may refer to as including fuse elements F1 and F2, which may be ignition and diagnosis targets, and/or peripheral circuits (a driving circuit 10, an ignition circuit 20, a diagnostic current supply circuit 30, and a resistance monitoring circuit 40).

When the battery pack P is applied to eVs, a protection function is generally applied to shut down the power of the battery pack when an impact, caused by a collision, is detected, but in some cases, the protection function may not operate. In instance when the protection function does not operate, a pyrofuse (or a pyroswitch) may be applied to the battery pack, used as a fuse element for blocking a current path connected to a battery. A pyrofuse is a fuse element that explodes when a current meets or exceeds a threshold value for ignition, thereby physically disconnecting wires disposed adjacent thereto. The fuse elements F1 and F2 constituting the fuse device F may be implemented as pyrofuses.

According to the ignition redundancy design of the pyrofuse, there are instances where a plurality of pyrofuses are applied to a battery pack P. However, a plurality of circuits are also required to ignite each pyrofuse, which may result in an increase of the size of a battery pack and/or an increase of manufacturing costs.

Advantageously, the fuse device F is capable of simultaneously igniting a plurality of fuse elements using a single peripheral circuit and integrally performing a fuse diagnosis operation.

### 2. Fuse device

FIG. 2 is a block diagram illustrating the fuse device. FIG. 3 is a circuit diagram of the fuse device.

Referring to FIG. 2, the fuse device F may include a first fuse element F1, a second fuse element F2, a driving circuit 10, an ignition circuit 20, a first current induction element D1, a second current induction element D2, a diagnostic current supply circuit 30, and a resistance monitoring circuit 40 (in FIG. 2, the first and second fuse elements F1 and F2 are modeled as internal resistors R_F1 and R_F2 of the fuse elements F1 and F2). The fuse device F may have, as signal input nodes, a driving signal input node to which a driving signal SIG_DRV for activating the driving circuit 10 is inputted, first and second ignition signal input nodes to which a first ignition signal SIG1_IGN and a second ignition signal SIG2_IGN for activating the ignition circuit 20 are inputted, respectively, and a diagnostic signal input node to which a diagnostic signal SIG_DIAG for activating the diagnostic current supply circuit 30 is inputted. The fuse device F may have a power node, to which a power voltage PWR is inputted. The power voltage PWR may be a relatively high voltage supplied from the main battery, a relatively low voltage supplied from the auxiliary battery, or a separate voltage (for example, VCC) generated by regulating a relatively high or low voltage. The fuse device F may have a first voltage output node and a second voltage output node, each of which respectively output voltages V1_SEN of the first fuse element F1 and V2_SEN of the second fuse element F2 (in particular, amplified values of the voltages V1_SEN and V2_SEN), as output nodes. The output voltages V1_SEN of the first fuse element F1 and V2_SEN of the second fuse element F2 may be transmitted to the processor CP.

Among signals inputted to the fuse device F, the driving signal SIG_DRV, the first ignition signal SIG1_IGN, and the diagnostic signal SIG_DIAG may be applied from the processor CP, and the second ignition signal SIG2_IGN may be applied from the upper level controller CTRLER (for example, an ECU of a vehicle). The first ignition signal SIG1_IGN may correspond to a signal transmitted to the fuse device F by the processor CP receiving a fuse ignition instruction from the upper level controller CTRLER when, for example, an impact of a vehicle is detected, and the second ignition signal SIG2_IGN may correspond to a signal transmitted directly to the fuse device F by the upper level controller CTRLER when an impact of the vehicle is detected.

Lower level components of the fuse device F are described in detail with reference to FIG. 3 (in FIG. 3, only components necessary to describe the operation of the fuse device F are indicated with symbols, and passive components not indicated with symbols refer to connection impedances applied in a typical circuit design).

The first fuse element F1 and the second fuse element F2 may be implemented as pyrofuses and may be configured to explode and block a current path connected to the battery BAT when a current having a magnitude meets or exceeds a threshold value for ignition. In FIG. 3, two fuse elements F1 and F2 are provided, but embodiments of the present disclosure may have three or more fuse elements. The two fuse elements F1 and F2 correspond to the minimum number of fuse elements that may be adopted, and it is to be noted that the present disclosure is not necessarily applied to only two fuse elements.

The driving circuit 10 may be configured to allow or block a current flowing from the power node to the first and second fuse elements F1 and F2, and for this purpose, the driving circuit 10 may include a main driving switch M1 and a sub-driving switch M2.

Describing a connection structure thereof as an example in which the main driving switch M1 and the sub-driving switch M2 are implemented as field effect transistors (FETs) (N-type), a gate terminal of the sub-driving switch M2 is connected to the driving signal input node through a connection resistor R13, and a source terminal thereof is connected to a ground node. A gate terminal of the main driving switch M1 is connected to each of a drain terminal of the sub-driving switch M2 and the power node through a connection resistor R11 and a connection resistor R12. A source terminal of the main driving switch M1 is connected to the power node, and a drain terminal thereof is connected to both the first and second fuse elements F1 and F2.

When the driving signal SIG_DRV having a relatively high level is inputted through the driving signal input node, the sub-driving switch M2 is turned on, and thus a current flows from the power node to the ground node through the connection resistors R11 and R12 and the drain terminal and the source terminal of the sub-driving switch M2. A voltage signal generated by a flowing current and the connection resistors R11 and R12 is generated at the gate terminal of the main driving switch M1, and thus the main driving switch M1 is turned on, thereby enabling a current to flow from the power node to the first and second fuse elements F1 and F2. When a state of the driving signal SIG_DRV is switched to a relatively low level state, the sub-driving switch M2 and the main driving switch M1 are turned off, thereby blocking a current flowing from the power node to the first and second fuse elements F1 and F2.

Accordingly, the driving circuit 10 may serve as a relatively high side switch that drives a current to flow to the first and second fuse elements F1 and F2 by controlling whether to electrically connect the first and second fuse elements F1 and F2, and a magnitude of a current flowing to the first and second fuse elements F1 and F2 is determined by the ignition circuit 20 and the diagnostic current supply circuit 30. When the battery pack P is in a wake-up state (that is, when the battery pack P is in normal operation), the processor CP may control the driving circuit 10 to maintain a turned-on state of the sub-driving switch M2 and the main driving switch M1. That is, the driving circuit 10 may always maintain an activated state with the exception of when an abnormality or short circuit occurs in the first and second fuse elements F1 and F2 and/or when the battery pack P is shut down.

The ignition circuit 20 may be configured to generate an ignition current for igniting the first fuse element F1 and the second fuse element F2. As the ignition current generated by the ignition circuit 20 flows to the first fuse element F1 and the second fuse element F2, the first fuse element F1 and the second fuse element F2 may be ignited so that the current path connected to the battery BAT may be blocked. The ignition circuit 20 may include an ignition switch M3 as a switch for forming an ignition current, and the ignition switch M3 may be implemented as a FET (N-type).

When nodes through which a current flows out of the first fuse element F1 and the second fuse element F2 based on the circuit of FIG. 3 are defined as a first node N1 and a second node N2 (that is, nodes opposite to nodes through which the first fuse element F1 and the second fuse element F2 are connected to the driving circuit 10), the ignition circuit 20 may be connected to the first fuse element F1 and the second fuse element F2 through a first branch path BRANCH1 and a second branch path BRANCH2, respectively, branching off from the first node N1 and the second node N2, respectively. The first current induction element D1 and the second current induction element D2, for inducing an ignition current to flow from the first node N1 and the second node N2 to the ignition circuit 20, respectively, may be connected to the first branch path BRANCH1 and the second branch path BRANCH2, respectively, and the first current induction element D1 and the second current induction element D2 may be implemented as diodes, respectively. An anode and a cathode of the first current induction element D1 are connected to the first node N1 and the drain terminal of the ignition switch M3, respectively, and an anode and a cathode of the second current induction element D2 are connected to the second node N2 and a drain terminal of the ignition switch M3, respectively.

The drain terminal of the ignition switch M3 is connected to both the first branch path BRANCH1 and the second branch path BRANCH2, and a source terminal thereof is connected to the ground node. A gate terminal of the ignition switch M3 is connected to the first ignition signal input node and the second ignition signal input node through a connection resistor R21 in an "OR" manner. A connection structure of an "OR" type may be implemented as a structure in which anodes of the diodes D3 and D4 are respectively connected to the first ignition signal input node and the second ignition signal input node, and cathodes of the diodes D3 and D4 are connected to both the gate terminal of the ignition switch M3 through the connection resistor R21. Accordingly, the ignition switch M3 may be turned on in response to an input of at least one of the first ignition signal SIG1_IGN and the second ignition signal SIG2_IGN. That is, the ignition switch M3 may be turned on when a state of at least one of the first ignition signal SIG1_IGN and the second ignition signal SIG2_IGN is a relatively high level state. The ignition circuit 20 may serve as a relatively low side switch that drives a current flow to the first fuse element F1 and the second fuse element F2 by controlling whether to electrically connect the first fuse element F1 and the second fuse element F2.

When the ignition switch M3 is turned on, an ignition current having a magnitude meeting or exceeding a threshold value may flow along a current path where the power node, the first fuse element F1, the first current induction element D1, the ignition switch M3, and the ground node are connected, so that the first fuse element F1 may be ignited. Similarly, an ignition current having a magnitude meeting of exceeding a threshold value may flow along a current path where the power node, the second fuse element F2, the second current induction element D2, the ignition switch M3, and the ground node are connected, so that the second fuse element F2 may be ignited (a magnitude of the power voltage PWR and resistance values of the internal resistors of the first fuse element F1 and the second fuse element F2 may be designed in advance as values for generating the ignition current having the magnitude meeting or exceeding the threshold value). The first fuse element F1 and the second fuse element F2 are ignited simultaneously. Because the ignition circuit 20 operates independent of other peripheral circuits, such as, the driving circuit 10, the diagnostic current supply circuit 30, and the resistance monitoring circuit 40, a reverse current that may flow from the ignition circuit 20 to other peripheral circuits may be prevented by the first current induction element D1 and the second current induction element D2. A redundant ignition structure capable of igniting a plurality of fuse elements through one ignition circuit 20 without affecting other peripheral circuits may be implemented.

The diagnostic current supply circuit 30 may be configured to generate a diagnostic current for diagnosing the first fuse element F1 and the second fuse element F2. As a diagnostic current flows in the first fuse element F1 and the second fuse element F2, voltages of the first fuse element F1 and the second fuse element F2 may be measured by the resistance monitoring circuit 40, and thus the processor CP may operate to monitor resistance values of the internal resistors of the first fuse element F1 and the second fuse element F2 based on the voltages measured by the resistance monitoring circuit 40.

The diagnostic current supply circuit 30 may include a first switch Q1 and a second switch Q2 respectively connected to the first fuse element F1 and the second fuse element F2 through the first node N1 and the second node N2, respectively. A third switch Q3 may be connected to the first switch Q1 through a mirror structure, and a first resistor R31 to a third resistor to R33 may be connected to the first switch Q1 to the third switch Q3, respectively.

Describing a connection structure as an example in which the first switch Q1 to the third switch Q3 are implemented as bipolar junction transistors (BJTs) (NPN), a collector terminal of the first switch Q1 is connected to the first node N1, and an emitter terminal thereof is connected to the ground node through the first resistor R31. A collector terminal of the second switch Q2 is connected to the second node N2, and an emitter terminal thereof is connected to the ground node through the second resistor R32. A base terminal of the first switch Q1, a base terminal of the second switch Q2, a base terminal of the third switch Q3, and a collector terminal of the third switch Q3 are connected in common, and a common connection node is connected to the diagnostic signal input node through a connection resistor R34. An emitter terminal of the third switch Q3 is connected to the ground node through the third resistor R33.

When the diagnostic signal SIG_DIAG having a relatively high level is inputted through the diagnostic signal input node, the third switch Q3 is turned on, and an output voltage of the third switch Q3 (that is, a collector terminal voltage of the third switch Q3) is amplified by the third resistor R33 and inputted into the base terminal of each of the first and second switches Q1 and Q2. Accordingly, the first switch Q1 is turned on so that a diagnostic current for the first fuse element F1 flows along the current path where the power node, the first fuse element F1, the first node N1, the first switch Q1, the first resistor R31, and the ground node are connected, and the second switch Q2 is turned on so that a diagnostic current for the second fuse element F2 flows along the current path where the power node, the second fuse element F2, the second node N2, the second switch Q2, the second resistor R32, and the ground node are connected.

According to the DC interpretation of a BJT, a magnitude of a diagnostic current (that is, a current value) flowing in the first fuse element F1 is determined by a magnitude of a base terminal voltage of the first switch Q1 (that is, a voltage value) and a resistance value of the first resistor R31 (that is, (base terminal voltage-threshold voltage) / (resistance value of the first resistor R31)). Assuming that the base terminal voltage is designed to have a fixed value according to the design specifications of the fuse device F, a magnitude of a diagnostic current flowing in the first fuse element F1 is determined to be dependent on a resistance value of the first resistor R31. Because the resistance value of the first resistor R31 is a constant value, the diagnostic current flowing in the first fuse element F1 is generated in the form of a constant current. The same applies to the second fuse element F2. Accordingly, the diagnostic current supply circuit 30 may serve as a constant current supply circuit. In order to prevent the first fuse element F1 and the second fuse element F2 from being ignited by a diagnostic current in a state in which the ignition switch M3 is turned off, resistance values of the first resistor and the second resistor may have values designed in advance to limit the diagnostic current.

Because a magnitude of a diagnostic current (for example, a constant current) is determined only by the first resistor R31 and the second resistor R32, a change in resistance value of the internal resistor of the first fuse element F1, a change in resistance value of the internal resistor of the second fuse element F2, or a change in the power voltage PWR, does not affect the magnitude of the diagnostic current. A method of generating a constant current enables implementation of an "internal resistor monitoring operation based on a voltage between both ends" using the resistance monitoring circuit 40.

Even when the ignition circuit 20 is activated (that is, the ignition switch M3 is turned on) in a state in which a diagnostic current generated by the diagnostic current supply circuit 30 is flowing in the first fuse element F1 and the second fuse element F2, the diagnostic current flowing in the first fuse element F1 and the second fuse element F2 maintains a constant magnitude, and an ignition current generated by the ignition circuit 20 is added to the diagnostic current to flow in the first fuse element F1 and the second fuse element F2. That is, irrespective of whether the diagnostic current supply circuit 30 is activated (that is, irrespective of whether a diagnostic current is flowing in the first fuse element F1 and the second fuse element F2), the ignition circuit 20 may operate to generate an ignition current to ignite the first fuse element F1 and the second fuse element F2.

The resistance monitoring circuit 40 may be connected to the first fuse element F1 and the second fuse element F2 to monitor a resistance value of the internal resistor of each of the first fuse element F1 and the second fuse element F2. The resistance monitoring circuit 40 may include a first monitoring circuit 41 for monitoring a resistance value of the internal resistor of the first fuse element F1 and a second monitoring circuit 42 for monitoring a resistance value of the internal resistor of the second fuse element F2.

The first monitoring circuit 41 may include a first amplifier AMP1 that amplifies the voltage V1_SEN of the first fuse element F1, and an output terminal of the first amplifier AMP1 is connected to the first voltage output node. Similarly, the second monitoring circuit 42 may include a second amplifier AMP2 that amplifies the voltage V2_SEN of the second fuse element F2, and an output terminal of the second amplifier AMP2 is connected to the second voltage output node. The first amplified AMP1 and the second amplifier AMP2 may be implemented as operational amplifiers (OP-AMPs).

The first monitoring circuit 41 and the second monitoring circuit 42 may operate in conjunction with the diagnostic current supply circuit 30. That is, the first monitoring circuit 41 and the second monitoring circuit 42 may measure the voltage V1_SEN of the first fuse element F1 and the voltage V2_SEN of the second fuse element F2, respectively, in a state in which a diagnostic current generated by the diagnostic current supply circuit 30 is flowing in the first fuse element F1 and the second fuse element F2, respectively.

Because a diagnostic current is a constant current, a change in the voltage V1_SEN of the first fuse element F1 depends only on a change in resistance value of the internal resistor of the first fuse element F1. The processor CP may calculate a resistance value of the internal resistor of the first fuse element F1 from the voltage V1_SEN of the first fuse element F1 and a magnitude of a diagnostic current (that is, a magnitude of a constant current which may be predefined by the processor CP), and when the calculated resistance value is outside a preset reference range, the processor CP may determine that an abnormality has occurred in the first fuse element F1. The reference range may be a resistance value range in which it may be determined that an abnormality or degradation has not occurred in the first fuse element F1 and may be predefined based on the designer's intention and experimental results by the processor CP. Such a configuration applies equally to the second fuse element F2.

### 3. Fuse device control operation by BMS

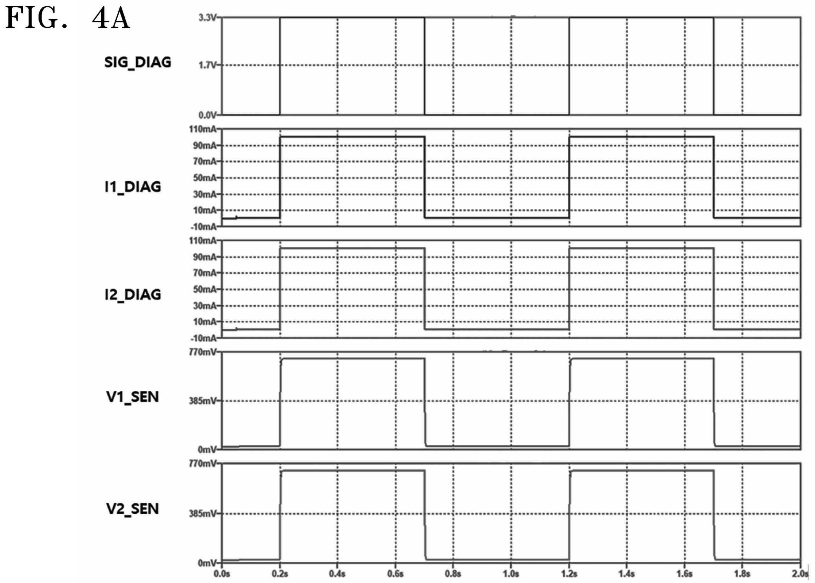

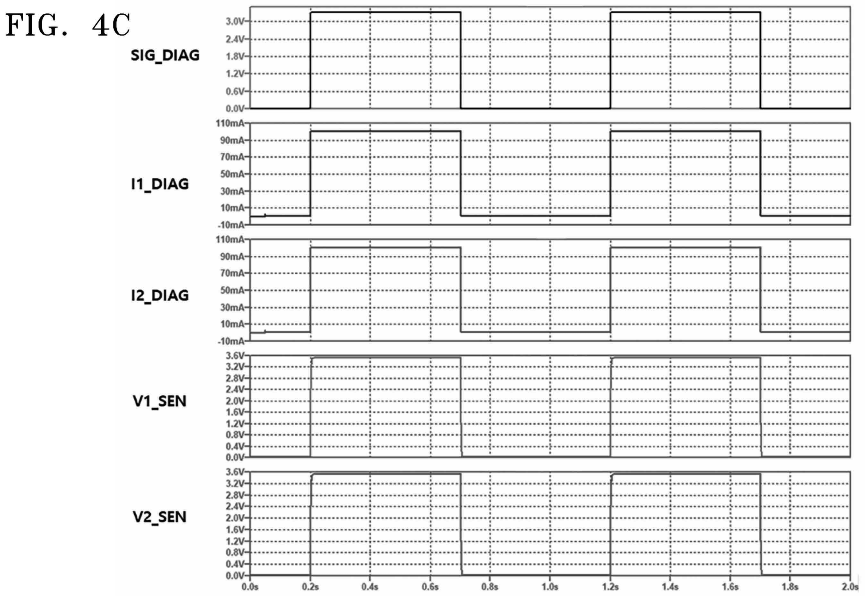

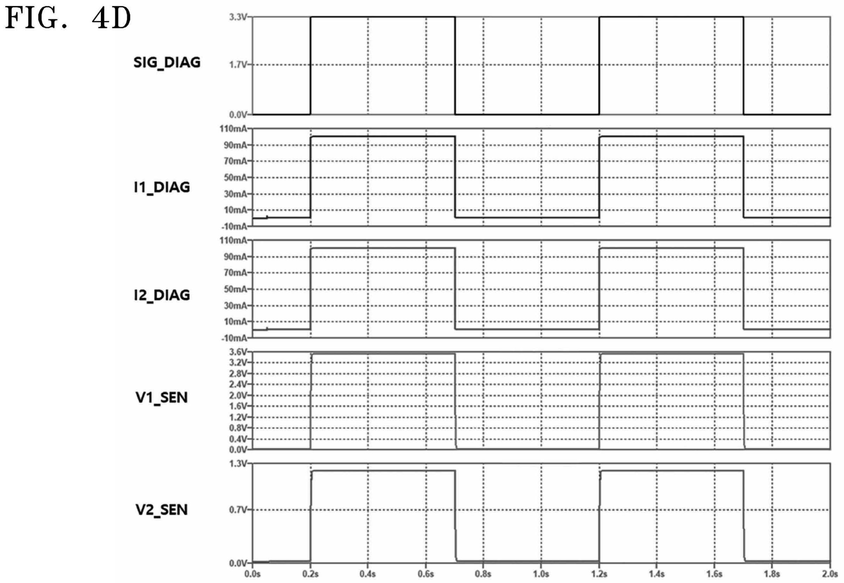

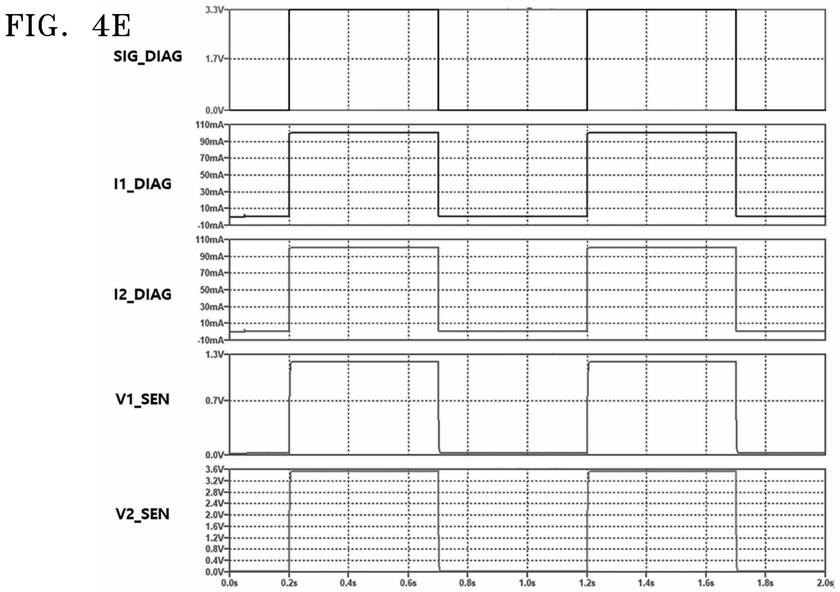

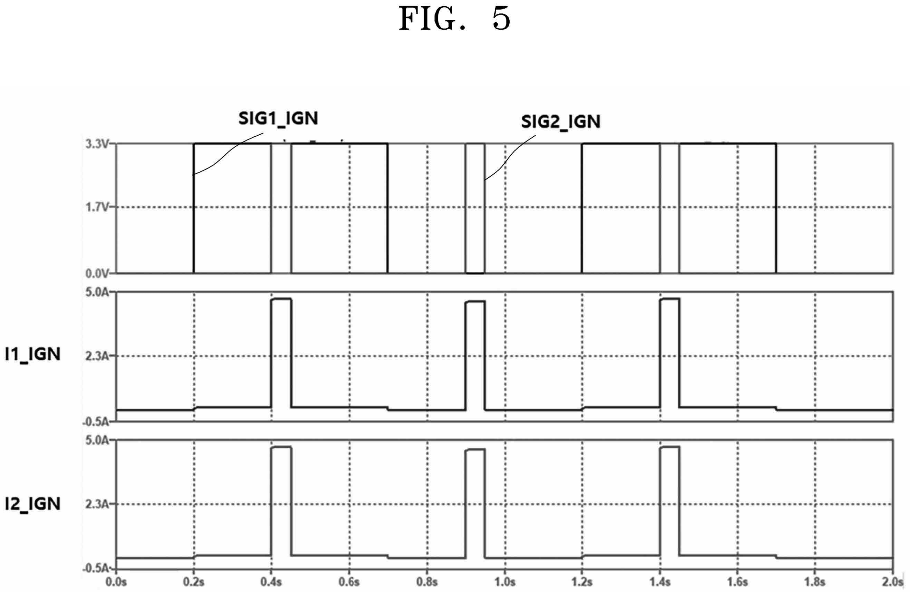

FIGS. 4A to 4E are diagrams describing a fuse diagnostic operation of the fuse device. FIG. 5 is a diagram describing a fuse ignition operation of the fuse device.

Based on a circuit structure of the fuse device F described with reference to FIG. 3, a fuse diagnosis operation for diagnosing an abnormality of the first fuse element F1 and the second fuse element F2 and a fuse ignition operation for igniting the first fuse element F1 and the second fuse element F2 is described in detail focusing on the processor CP of the BMS.

When the fuse diagnostic operation is performed, the processor CP may activate the driving circuit 10 by inputting the driving signal SIG_DRV having a relatively high level to the driving signal input node of the fuse device F. Accordingly, the sub-driving switch M2 and the main driving switch M1 are sequentially turned on, and a current flows from the power node to the first fuse element F1 and the second fuse element F2. At the same time, the processor CP may deactivate the ignition circuit 20 by inputting the first ignition signal SIG1_IGN having a relatively low level to the first ignition signal input node and may activate the diagnostic current supply circuit 30 by inputting the diagnostic signal SIG_DIAG having a relatively high level to the diagnostic signal input node. Accordingly, the first switch Q1 is turned on so that a diagnostic current for the first fuse element F1 flows along the current path where the power node, the first fuse element F1, the first node N1, the first switch Q1, the first resistor R31, and the ground node are connected, and the second switch Q2 is turned on so that a diagnostic current for the second fuse element F2 flows along the current path where the power node, the second fuse element F2, the second node N2, the second switch Q2, the second resistor R32, and the ground node are connected.

The diagnostic current flowing in the first fuse element F1 and the second fuse element F2 is generated in the form of a constant current having a predefined magnitude according to resistance values of the first resistor R31 and the second resistor R32, respectively. Because a magnitude of a diagnostic current (for example, a constant current) is determined only by the first resistor R31 and the second resistor R32, a change in resistance value of the internal resistor of the first fuse element F1 or a change in resistance value of the internal resistor of the second fuse element F2 does not affect the magnitude of the diagnostic current. When resistance values of the first resistor R31 and the second resistor R32 are the same, magnitudes of constant currents flowing in the first fuse element F1 and the second fuse element F2 are also the same. The magnitude of the constant current flowing in the first fuse element F1 and the second fuse element F2 may be predefined as a design specification by the processor CP.

When a diagnostic current flows in the first fuse element F1 and the second fuse element F2, the processor CP may monitor a resistance value of the internal resistor of the first fuse element F1 and a resistance value of the internal resistor of the second fuse element F2 through the resistance monitoring circuit 40. Specifically, the processor CP may monitor the resistance values of the internal resistors of the first fuse element F1 and the second fuse element F2 by calculating the resistance value of the internal resistor of the first fuse element F1 and the resistance value of the internal resistor of the second fuse element F2 based on the voltage V1_SEN of the first fuse element F1 detected through the first monitoring circuit 41, the voltage V2_SEN of the second fuse element F2 detected through the second monitoring circuit 42, and a magnitude of a diagnostic current (constant current).

FIGS. 4A to 4E illustrate magnitudes of a diagnostic current and the voltages V1_SEN and V2_SEN of the internal resistors, which are generated according to the resistance value of the internal resistor of the first fuse element F1 and the resistance value of the internal resistor of the second fuse element F2. The magnitudes are summarized in a table as follows (numerical values in Table 1 below are approximate values and presuppose a case in which the first and second resistors R31 and R32 have the same resistance value). In FIGS. 4A to 4E, SIG_DIAG indicates a diagnostic signal, I1_DIAG and I2_DIAG indicate diagnostic currents flowing in the first and second fuse elements F1 and F2, respectively, and V1_SEN and V2_SEN indicate voltages of the first and second fuse elements F1 and F2, respectively.

**[Table 1]**

| | SIG_DIAG @ high level [V] | I1_DIAG [mA] | I2_DIAG [mA] | V1_SEN [V] | V2_SEN [V] |
|---|---|---|---|---|---|
| [FIG. 4A] R_F1=R_F2= 1 Ω | 3.3 | 100 | 100 | 0.75 | 0.75 |
| [FIG. 4B] R_F1=R_F2= 1.7 Ω | 3.3 | 100 | 100 | 1.2 | 1.2 |
| [FIG. 4C] R_F1=R_F2= 5 Ω | 3.3 | 100 | 100 | 3.6 | 3.6 |
| [FIG. 4D] R_F1=5 Ω and R_F2=1.7 Ω | 3.3 | 100 | 100 | 3.6 | 1.2 |
| [FIG. 4E] R_F1=1.7 Ω and R_F2=5 Ω | 3.3 | 100 | 100 | 1.2 | 3.6 |

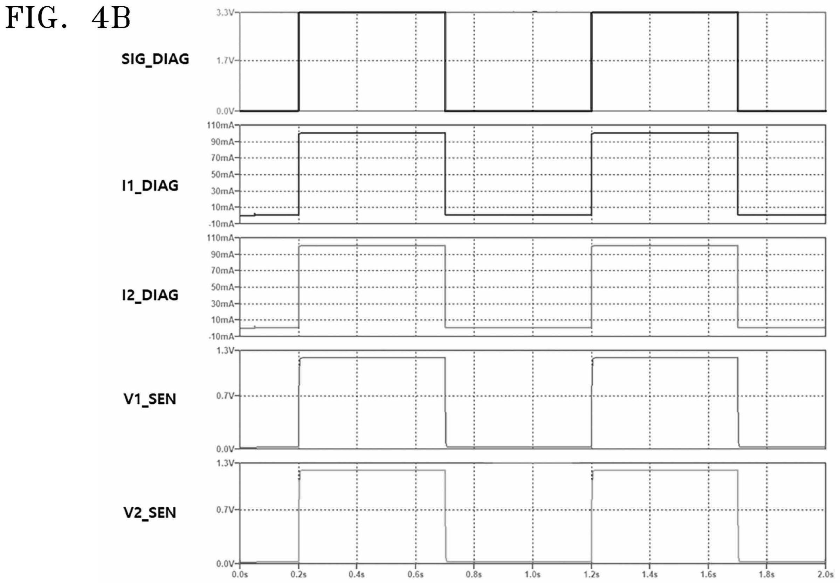

As shown in FIGS. 4A to 4E and Table 1, even when the resistance value of the internal resistor of the first fuse element F1 or the resistance value of the internal resistor of the second fuse element F2 changes, the magnitude of the diagnostic current (constant current) remains constant at 100 mA. Because the magnitude of the diagnostic current remains constant, it can be confirmed that a change in the resistance value of the internal resistor of the first fuse element F1 or the resistance value of the internal resistor of the second fuse element F2 is expressed as a change in voltage of a corresponding fuse element. For example, referring to FIGS. 4A and 4B, it can be confirmed that when the resistance value of the internal resistor of the fuse element increases from 1 Ω to 1.7 Ω, the voltage V1_SEN of the first fuse element F1 and the voltage V2_SEN of the second fuse element F2 increase from 0.75 V to 1.2 V. That is, because the diagnostic current is generated as a constant current, an abnormality of the first fuse element F1 and the second fuse element F2 may be readily detected only by measuring the voltage V1_SEN of the first fuse element F1 and the voltage V2_SEN of the second fuse element F2.

When the resistance value of the internal resistor of the first fuse element F1 or the resistance value of the internal resistor of the second fuse element F2 is outside a preset reference range, the processor CP may determine that an abnormality has occurred in the first fuse element F1 or the second fuse element F2. The reference range may be a resistance value range in which it may be determined that an abnormality or degradation has not occurred in the first fuse element F1 and the second fuse element F2 and may be predefined based on the designer's intention and experimental results by the processor CP.

When it is determined that an abnormality has occurred in the first fuse element F1 or the second fuse element F2, the processor CP may control the driving circuit 10 to block a current flowing from the power node to the first fuse element F1 and the second fuse element F2. That is, in order to prevent additional damage to the fuse elements that may be caused by a current being continuously applied from the power node to the first fuse element F1 and the second fuse element F2 even when an abnormality has occurred in the first fuse element F1 or the second fuse element F2, the processor CP may deactivate the driving circuit by inputting the driving signal SIG_DRV having a low level to the driving signal input node.

The processor CP may determine whether the first fuse element F1 or the second fuse element F2 is shorted based on the voltage V1_SEN of the first fuse element F1 and the voltage V2_SEN of the second fuse element F2 detected through the resistance monitoring circuit 40, and when a short circuit of the first fuse element F1 or the second fuse element F2 is detected, the processor CP may control the driving circuit 10 to block a current flowing from the power node to the first fuse element F1 and the second fuse element F2. That is, when the voltage V1_SEN of the first fuse element F1 detected through the first monitoring circuit 41 has a value of 0, the processor CP may determine that both ends of the first fuse element F1 are shorted, when the voltage V2_SEN of the second fuse element F2 detected through the second monitoring circuit 42 has a value of 0, the processor CP may determine that both ends of the second fuse element F2 are shorted, and when a short circuit of the first fuse element F1 or the second fuse element F2 is detected, the processor CP may deactivate the driving circuit by inputting the driving signal SIG_DRV having a low level to the driving signal input node. Accordingly, it is possible to prevent damage to the fuse device F that may be caused as a current continuously flows through a short circuit.

When the fuse ignition operation is performed, the processor CP controls the ignition circuit 20 to allow ignition currents to simultaneously flow in the first fuse element F1 and the second fuse element F2, thereby simultaneously igniting the first fuse element F1 and the second fuse element F2.

Specifically, the processor CP may activate the ignition circuit 20 by inputting the first ignition signal SIG1_IGN having a high level to the first ignition signal input node. By a turn-on operation of the ignition switch M3, an ignition current having a magnitude meeting or exceeding a threshold value may flow along a first current path where the power node, the first fuse element F1, the first current induction element D1, the ignition switch M3, and the ground node are connected, so that the first fuse element F1 maybe ignited, and similarly, an ignition current having a magnitude meeting or exceeding a threshold value may flow along a second current path where the power node, the second fuse element F2, the second current induction element D2, the ignition switch M3, and the ground node are connected, so that the second fuse element F2 may be ignited. When the ignition circuit 20 is activated, the first current path and the second current path may be simultaneously formed, and thus ignition currents may simultaneously flow in the first fuse element F1 and the second fuse element F2 so that the first fuse element F1 and the second fuse element F2 may be simultaneously ignited. The fuse ignition operation is performed in the same manner even when the second ignition signal SIG2_IGN having a relatively high level is inputted from the upper level controller CTRLER into the second ignition signal input node.

FIG. 5 illustrates magnitudes of ignition currents generated during a fuse ignition operation and voltages of the fuse elements, and the magnitudes are summarized in a table as follows (numerical values in Table 2 below are approximate values and presuppose a case in which the first and second resistors R31 and R32 have the same resistance value). In FIG. 5, SIG1_IGN and SIG2_IGN indicate the first and second ignition signals, respectively, and I1_IGN and I2_IGN indicate ignition currents flowing in the first and second fuse elements F1 and F2, respectively.

**[Table 2]**

| | SIG1_IGN and SIG2_IGN @ high level [V] | I1_IGN [A] | I2_IGN [A] |
|---|---|---|---|
| R_F1=R_F2=1.7 Ω | 3.3 | 4.8 | 4.8 |

As shown in FIG. 5 and Table 2, when the ignition circuit 20 is activated, an ignition current (e.g. 4.8 A) may flow in the first fuse element F1 and the second fuse element F2 so that the first fuse signal and the second fuse signal may be ignited. The fuse ignition operation may be performed irrespective of whether a diagnostic current is flowing in the first fuse element F1 and the second fuse element F2 (that is, irrespective of whether a diagnostic current supply signal is activated), that is, the fuse ignition operation and the fuse diagnostic operation may each be independently performed.

Advantageously, the present disclosure provides a diagnosis and ignition mechanism that independently and integrally performs a fuse diagnosis operation of monitoring the internal resistor of a fuse element by measuring a voltage of a fuse element in a state in which a diagnostic current (constant current) for diagnosing the fuse element flows in the fuse element, and a fuse ignition operation of igniting the fuse element by allowing an ignition current for igniting the fuse element to flow in the fuse element.

Because a driving circuit 10, an ignition circuit 20, and a resistance monitoring circuit 40, required for diagnosing and igniting a fuse element, are shared by a plurality of fuse elements, a circuit topology capable of performing concurrent diagnosis and concurrent ignition on the plurality of fuse elements may be provided.

However, effects that can be achieved through the present invention are not limited to the above-described effects and other effects that are not described may be clearly understood by those skilled in the art from the detailed descriptions.

Implementations described herein may be implemented in, for example, a method or process, an apparatus, a software program, a data stream, or a signal. Although discussed only in the context of a single form of implementation (e.g., discussed only as a method), implementations of the discussed features may also be implemented in other forms (for example, an apparatus or a program). The apparatus may be implemented in suitable hardware, software, firmware, and the like. A method may be implemented in an apparatus such as a processor, which is generally a computer, a microprocessor, an IC, a processing device including a programmable logic device, or the like. Processors also include communication devices such as a computer, a cell phone, a portable/personal digital assistant ("PDA"), and other devices that facilitate communication of information between end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure.

Embodiments are set out in the following numbered clauses:
Clause 1. A fuse device for diagnosing and igniting a fuse, the fuse device comprising: a first fuse element and a second fuse element, each configured to block a current path connected to a battery; a diagnostic current supply circuit connected to each of the first fuse element and the second fuse element through a first node and a second node, respectively, the diagnostic current supply circuit configured to allow a diagnostic current to flow in each of the first fuse element and the second fuse element; and an ignition circuit connected to each of the first fuse element and the second fuse element through a first branch path and a second branch path, respectively, each branching off from the first node and the second node, respectively, the ignition circuit configured to allow an ignition current to flow in each of the first fuse element and the second fuse element.
Clause 2. The fuse device of clause 1, further comprising a first current induction element and a second current induction element connected to the first branch path and the second branch path, respectively, and the first current induction element and the second current induction element each configured to induce the ignition current to flow from the first node and from the second node, respectively, to the ignition circuit.
Clause 3. The fuse device of clause 2, wherein the ignition circuit includes an ignition switch configured to be turned on in response to an input of a first ignition signal or a second ignition signal to generate the ignition current in the first fuse element and the second fuse element, wherein the first ignition signal is applied by a first processor configured to control the fuse device, and wherein the second ignition signal is applied by a second processor corresponding to an upper level controller to the first processor.
Clause 4. The fuse device of clause 1, 2 or 3, wherein the diagnostic current supply circuit includes a first switch, a second switch, a first resistor connected to the first switch, and a second resistor connected to the second switch, wherein when the first switch is turned on, the diagnostic current for the first fuse element flows along a current path where the first fuse element, the first node, the first switch, the first resistor, and a ground node are connected, and wherein when the second switch is turned on, the diagnostic current for the second fuse element flows along a current path where the second fuse element, the second node, the second switch, the second resistor, and the ground node are connected.
Clause 5. The fuse device of clause 4, wherein the diagnostic current is a constant current of which a magnitude is determined by a resistance value of the first resistor or the second resistor.
Clause 6. The fuse device of any one previous clause, further comprising a resistance monitoring circuit including a first monitoring circuit configured to monitor a resistance value of an internal resistor of the first fuse element, and a second monitoring circuit configured to monitor a resistance value of an internal resistor of the second fuse element.
Clause 7. The fuse device of clause 6, wherein the first monitoring circuit includes a first amplifier configured to amplify a voltage of the first fuse element, and wherein the second monitoring circuit includes a second amplifier configured to amplify a voltage of the second fuse element.
Clause 8. The fuse device of clause 6 or 7, further comprising a driving circuit configured to allow or block a current flowing from a power node to the first fuse element or the second fuse element.
Clause 9. The fuse device of clause 8, wherein, when the resistance value of the internal resistor of the first fuse element or the resistance value of the internal resistor of the second fuse element is outside a preset reference range, the driving circuit is configured to block the current flowing to the first fuse element or the second fuse element.
Clause 10. A battery management system comprising: a first fuse element and a second fuse element, each configured to block a current path connected to a battery; a diagnostic current supply circuit connected to each of the first fuse element and the second fuse element, the diagnostic current supply circuit configured to allow a diagnostic current to flow in each of the first fuse element and the second fuse element; an ignition circuit connected to each of the first fuse element and the second fuse element, the ignition circuit configured to allow an ignition current to flow in each of the first fuse element and the second fuse element; and a processor configured to control the diagnostic current supply circuit and the ignition circuit to independently perform diagnosing of the first fuse element and the second fuse element or perform igniting of the first fuse element and the second fuse element.
Clause 11. The battery management system of clause 10, wherein the processor is configured to control the diagnostic current supply circuit to allow a constant current having a predefined magnitude to flow in the first fuse element and the second fuse element as the diagnostic current.
Clause 12. The battery management system of clause 10 or 11, further comprising a resistance monitoring circuit including a first monitoring circuit configured to monitor a resistance value of an internal resistor of the first fuse element, and a second monitoring circuit configured to monitor a resistance value of an internal resistor of the second fuse element.
Clause 13. The battery management system of clause 12, further comprising a driving circuit configured to allow or block a current flowing from a power node to the first fuse element or the second fuse element.
Clause 14. The battery management system of clause 13, wherein the processor is configured to control the diagnostic current supply circuit to allow the diagnostic current to flow in the first fuse element or the second fuse element.
Clause 15. The battery management system of clause 13 or 14, wherein the processor is configured to monitor the resistance value of the internal resistor of the first fuse element and the resistance value of the internal resistor of the second fuse element.
Clause 16. The battery management system of clause 14 or 15, wherein, when the resistance value of the internal resistor of the first fuse element or the resistance value of the internal resistor of the second fuse element is outside a preset reference range, the processor is configured to determine that an abnormality has occurred in the first fuse element or the second fuse element.
Clause 17. The battery management system of clause 16, wherein, when the processor determines that the abnormality has occurred, the processor is configured to control the driving circuit to block the current flowing from the power node to the first fuse element or the second fuse element.
Clause 18. The battery management system of any one of clauses 13 to 17, wherein the processor is configured to determine whether the first fuse element or the second fuse element is shorted based on a voltage of the first fuse element and a voltage of the second fuse element detected through the resistance monitoring circuit.
Clause 19. The battery management system of any one of clauses 10 to 18, wherein the ignition circuit is connected to each of the first fuse element and the second fuse element via a first current induction element and a second current induction element, respectively.
Clause 20. A battery pack comprising: a battery; a first fuse element and a second fuse element, each configured to block a current path connected to the battery; a diagnostic current supply circuit connected to each of the first fuse element and the second fuse element, the diagnostic current supply circuit configured to allow a diagnostic current to flow in each of the first fuse element and the second fuse element; an ignition circuit connected to each of the first fuse element and the second fuse element, the ignition circuit configured to allow an ignition current to flow in each of the first fuse element and the second fuse element; and a processor configured to control the diagnostic current supply circuit and the ignition circuit to independently perform diagnosing of the first fuse element and the second fuse element or perform igniting of the first fuse element and the second fuse element.

## Claims

1. A fuse device for diagnosing and igniting a fuse, the fuse device comprising:
a first fuse element (F1) and a second fuse element (F2), each configured to block a current path connected to a battery (BAT);
a diagnostic current supply circuit (30) connected to the first fuse element (F1) and the second fuse element (F2), the diagnostic current supply circuit (30) configured to allow a diagnostic current to flow in each of the first fuse element (F1) and the second fuse element (F2); and
an ignition circuit (20) connected to the first fuse element (F1) and the second fuse element (F2), the ignition circuit (20) configured to allow an ignition current to flow in each of the first fuse element (F1) and the second fuse element (F2).

2. The fuse device of claim 1, wherein the diagnostic current supply circuit (30) is connected to each of the first fuse element (F1) and the second fuse element (F2) through a first node (N1) and a second node (N2), respectively, and the ignition circuit (20) connected to each of the first fuse element (F1) and the second fuse element (F2) through a first branch path (BRANCH1) and a second branch path (BRANCH2), respectively, each branching off from the first node (N1) and the second node (N2), respectively.

3. The fuse device of claim 2, further comprising a first current induction element (D1) and a second current induction element (D2) connected to the first branch path (BRANCH1) and the second branch path (BRANCH2), respectively, and the first current induction element (D1) and the second current induction element (D2) each configured to induce the ignition current to flow from the first node (N1) and from the second node (N2), respectively, to the ignition circuit (20).

4. The fuse device of claim 3, wherein the ignition circuit (20) includes an ignition switch (M3) configured to be turned on in response to an input of a first ignition signal (SIG1_IGN) or a second ignition signal (SIG2_IGN) to generate the ignition current in the first fuse element (F1) and the second fuse element (F2),
wherein the first ignition signal (SIG1_IGN) is applied by a first processor (CP) configured to control the fuse device (F), and
wherein the second ignition signal (SIG2_IGN) is applied by a second processor (CTRLER) corresponding to an upper level controller to the first processor (CP).

5. The fuse device of claim 2, 3, or 4, wherein the diagnostic current supply circuit (30) includes a first switch (Q1), a second switch (Q2), a first resistor (R31) connected to the first switch (Q1), and a second resistor (R32) connected to the second switch (Q2),
wherein when the first switch (Q1) is turned on, the diagnostic current for the first fuse element (F1) flows along a current path where the first fuse element (F1), the first node (N1), the first switch (Q1), the first resistor (R31), and a ground node are connected, and
wherein when the second switch (Q2) is turned on, the diagnostic current for the second fuse element (F2) flows along a current path where the second fuse element (F2), the second node (N2), the second switch (Q2), the second resistor (R32), and the ground node are connected.

6. The fuse device of claim 5, wherein the diagnostic current is a constant current of which a magnitude is determined by a resistance value of the first resistor (R31) or the second resistor (R32).

7. The fuse device of any one of claims 1 to 6, further comprising a resistance monitoring circuit (40) including a first monitoring circuit (41) configured to monitor a resistance value of an internal resistor (R_F1) of the first fuse element (F1), and a second monitoring circuit (42) configured to monitor a resistance value of an internal resistor (R_F2) of the second fuse element (F2).

8. The fuse device of claim 7, wherein the first monitoring circuit (41) includes a first amplifier (AMP1) configured to amplify a voltage of the first fuse element (F1), and
wherein the second monitoring circuit (42) includes a second amplifier (AMP2) configured to amplify a voltage of the second fuse element (F2).

9. The fuse device of any one of claims 1 to 8, further comprising a driving circuit (10) configured to allow or block a current flowing from a power node (PWR) to the first fuse element (F1) or the second fuse element (F2).

10. The fuse device of claim 9 when dependent on claims 7 or 8 only, wherein, when the resistance value of the internal resistor (R_F1) of the first fuse element (F1) or the resistance value of the internal resistor (R_F2) of the second fuse element (F2) is outside a preset reference range, the driving circuit (10) is configured to block the current flowing to the first fuse element (F1) or the second fuse element (F2).

11. A battery management system comprising the fuse device of any one of claims 1 to 10, and a processor (CP) configured to control the diagnostic current supply circuit (30) and the ignition circuit (20) to independently perform diagnosing of the first fuse element (F1) and the second fuse element (F2) or perform igniting of the first fuse element (F1) and the second fuse element (F2).

12. The battery management system of claim 11, wherein the processor (CP) is configured to control the diagnostic current supply circuit (30) to allow a constant current having a predefined magnitude to flow in the first fuse element (F1) and the second fuse element (F2) as the diagnostic current.

13. The battery management system of claim 12, further comprising a driving circuit (10) configured to allow or block a current flowing from a power node (PWR) to the first fuse element (F1) or the second fuse element (F2), optionally wherein, when the resistance value of the internal resistor (R_F1) of the first fuse element (F1) and the resistance value of the internal resistor (R_F2) of the second fuse element (F2) are monitored, the processor (CP) controls the driving circuit (10) to allow the current to flow from the power node (PWR) to the first fuse element (F1) and the second fuse element (F2).

14. The battery management system of claim 13, wherein the processor (CP) is configured to control the diagnostic current supply circuit (30) to allow the diagnostic current to flow in the first fuse element (F1) or the second fuse element (F2)second fuse element (F2), and optionally to monitor the resistance value of the internal resistor (R_F1) of the first fuse element (F1) and the resistance value of the internal resistor (R_F2) of the second fuse element (F2), further optionally wherein the processor (CP) is configured to conduct said monitoring through the resistance monitoring circuit (40) in a state in which the diagnostic current flows in the first fuse element and the second fuse element (F2).

15. The battery management system of any one of claims 11 to 14, wherein the ignition circuit (20) is connected to the first fuse element (F1) and the second fuse element (F2) via a first current induction element (D1) and a second current induction element (D2), respectively, optionally wherein
the processor (CP) controls the ignition circuit (20) so that the ignition current simultaneously flows in the first fuse element (F1) and the second fuse element (F2) to simultaneously ignite the first fuse element and the second fuse element (F2).
